# EUROPÄISCHE PATENTSCHRIFT

(11) **EP 1 530 055 B1**
(45) Veröffentlichungstag und Bekanntmachung des Hinweises auf die Patenterteilung: **28.11.2007**
(21) Anmeldenummer: 04025820.4
(22) Anmeldetag: 29.10.2004
(51) Int. Cl.: G01R 31/28

(54) **Vorrichtung zum Prüfen elektrischer Bauteile**
Device for testing of electronic components
Dispositif pour tester des composants électroniques

(30) Priorität: 10.11.2003 DE 20317276 U
(43) Veröffentlichungstag der Anmeldung: 11.05.2005
(73) Patentinhaber: Teco GmbH, 80339 München (DE)
(72) Erfinder: Quitt, Ullrich c/o TECO Gmbh, 80339 München (DE)
(74) Vertreter: Baronetzky, Klaus

(56) Entgegenhaltungen:
- EP-A- 0 651 260
- EP-A- 0 961 128
- DE-U1- 9 201 067
- NL-C2- 1 007 474
- US-A- 5 149 029

## Beschreibung

Die Erfindung betrifft eine Vorrichtung zum Prüfen elektrischer Bauteile, insbesondere elektronischer Baugruppen, mit einer Transporteinrichtung zum Zuführen der zu prüfenden Bauteile und mindestens einem Satz Prüfkassetten, die mit den Kontakten des zu prüfenden Bauteils in Eingriff gebracht werden, wobei die Vorrichtung einen Rahmen aufweist, an dem eine obere Prüfkassette fest und eine untere Prüfkassette bewegbar gelagert ist, und der Rahmen ein Stellglied trägt, das zum Verschieben der unteren Prüfkassette in Richtung des Prüflings angeordnet ist.

Bei den bekannten Vorrichtungen zum Prüfen elektronischer Baugruppen werden die Prüflinge mechanisch, manuell oder in sonstiger Weise zugeführt, in der Vorrichtung ausgerichtet und die Kontaktverbindungen hergestellt. Das Ausrichten geschieht im Allgemeinen mit Fangstiften, die in dafür definierte Bohrungen des Prüflings greifen. Das Herstellen der Kontaktverbindungen geschieht im Allgemeinen mittels im Prüfkopf oder in einer wechselbaren Prüfkassette prüflingsspezifisch eingebrachten gefederten Kontaktstiften, die auf dafür vorgesehenen Stellen am Prüfling, auf Stecker oder andere geeignete Punkte auftreffen und dort den Kontakt herstellen. Die Prüfköpfe enthalten zu diesem Zweck Führungselemente, die die Ausrichtung der Komponenten der Vorrichtung gewährleisten, Antriebselemente, die die Schließkraft erzeugen, sowie prüflingsspezifische austauschbare Nadelbett-Kassetten mit Positionierstiften, Kontaktnadeln und, auf der entgegengesetzten Kassette, Niederhalter und, bei Bedarf, nochmals Kontaktnadeln.

Prüfvorrichtungen, die speziell als Teil einer Fertigungslinie von einem Band oder ähnlichen Transportmittel beschickt werden oder Prüfvorrichtungen, die als alleinstehende Einheiten betrieben werden, drücken üblicherweise den Prüfling meist zusammen mit seinem Transportmittel, beispielsweise einem Transportband, auf das Nadelbett hinunter. Dies erfordert eine Unterteilung des Transportwegs im Bereich der Prüfvorrichtung und dass der Prüfling zusammen mit dem Transportmittel in Richtung des Nadelbetts bewegt wird.

Die Druckschrift EP-A-0 961 128 beschreibt ein solches Testsystem für Leiterplatten, bei dem durch eine höhenjustierbare mechanische Druckanordnung mittels einer Lineargetriebe-/Hebelkombination die zu prüfende Leiterplatte auf eine herkömmliche Sondentestvorrichtung gedrückt werden soll. Während des Testvorgangs muss das Band jedoch angehalten werden.

In der Druckschrift NL-C-1 007 474 wird ebenfalls eine Testvorrichtung für gedruckte Schaltungen beschrieben, bei der mittels einer Vielzahl von Niederhaltern die zu testende Platine auf das Nadelbett der Baugruppentestsonde, das sich unterhalb der Fördervorrichtung befindet, gedrückt wird. Auch bei diesem System muss das Band während der Prüfung angehalten werden.

Die Druckschrift DE-U-9 201 067 beschreibt einen Baugruppentester, der auf einem Grundgestell in Richtung der Transporteinrichtung verfahrbar ist und ein Gehäuse zur Aufnahme der Elektronik aufweist, an dessen oberem Ende eine obere Prüfkassette über den zu prüfenden Bauteil schwenkbar gelagert ist, während die untere Prüfkassette auf einem Kragarm in Richtung des zu prüfenden Bauteils verschiebbar ist. Sobald der Baugruppentester neben der Transporteinrichtung in Position gebracht ist, wird durch die einseitig gelagerte Hubeinheit die zu prüfende Baugruppe vom Transportband abgehoben.

Bei einigen bekannten Vorrichtungen muss das Band für die Zeitspanne der Prüfung angehalten werden. Es muss vom Antrieb mitbewegt werden und erfordert einen eigenen Aufwand an Lagerung. Die nachfolgende Baugruppe muss einen gewissen Abstand von der eigentlichen Prüfvorrichtung einhalten, da es sonst auf dem Bandabschnitt mitfährt und steuerungstechnisch nur schwer erfassbar ist.

Im Übrigen muss das zuführende Transportband sich bei der Herstellung der Kontaktverbindung in Richtung der Kontakte mitbewegen und also angehalten werden.

Aufgabe der vorliegenden Erfindung ist es, die Kontaktierung zu vereinfachen, den Teilewechsel zu beschleunigen und das zuführende Transportband kontinuierlich umlaufen lassen zu können und nicht aus seiner Bewegungsebene heraus absenken zu müssen.

Zur Lösung dieser Aufgabe wird eine Vorrichtung gemäß Anspruch 1 vorgeschlagen.

Hierdurch wird der Vorteil erreicht, dass das zuführende Transportband bei der Herstellung der Kontakte weiter und ununterbrochen umlaufen kann und nicht aus seiner Laufebene bzw. Bezugsebene der Vorrichtung abgesenkt wird.

Das zuführende Transportband wird während des Prüfvorgangs nicht angehalten, da der Prüfling während des Prüfvorgangs von dem Transportband abgehoben ist.

Der Prüfkopf macht zwei Teilhübe, die so den Prüfling bzw. den in einem Warenträger angeordneten Prüfling von dem Transportband ausheben und in weiterer Abfolge des Hubs von den von oben gegen den Prüfling drückenden Niederhaltern gegen die Kontaktstifte der Prüfkassette drücken.

Es können sowohl einseitige (im Allgemeinen von unten) als auch doppelseitige Kontaktierung (von oben und unten) vorgesehen werden.

Ein besonderer Vorteil besteht darin, dass das Transportband während des Prüfvorgangs weiterläuft und den nächsten Prüfling in unmittelbare Nähe der Prüfvorrichtung bringt. Dies verringert beim nächsten Prüflingswechsel die Bearbeitungsdauer.

Das Transportband kann einfacher und stabiler ausgeführt werden, da es nicht zusammen mit dem Prüfling auf der Bezugsebene herausbewegt wird. Es treten keine einseitigen Kräfte auf, die zu einer unzulässigen Belastung des Prüflings führen könnten.

Der Prüfling ist bis auf die zu vernachlässigende Federkraft der Auswerfstifte, welche ein vorzeitiges Absinken des Prüflings auf die Kontaktstifte verhindern, keinen fremden Kräften außer derjenigen zum Einfedern der Kontaktnadeln erforderlichen Kräften ausgesetzt. Die Summe der Federkräfte der Auswerfer entsprechen größenordnungsmäßig dem Eigengewicht der Baugruppe.

Die Kontaktierung ist in ihrer Höhe gegenüber dem Transportband nicht zwingend festgelegt und durch Änderungen des Anschlags der unteren Kassette gegenüber der Bezugsebene leicht möglich.

Dieser Anschlag muss nicht die Schließkraft des Hauptzylinders, sondern nur die des Eigengewichts des Prüfkopfs übersteigende Kraft der Stützzylinder aufnehmen und an die Bezugsebene, normalerweise das Transportband, bringen.

Prüflinge stark unterschiedlicher Dicken und Höhen können ohne Umrüstung der Prüfvorrichtung geprüft werden. Es ist lediglich ein Auswechseln der Prüfkassetten erforderlich, da der Aufbau der Schließkraft des Hauptzylinders unabhängig von einem bereits gefahrenen Weg erst nach Niederdrücken des Prüflings in das Nadelbett aufgebaut wird.

Dies stellt einen großen Vorteil gegenüber Prüfköpfen mit fest definiertem Weg dar. Das Hubende des Hauptzylinders wird durch das Auftreffen von Distanzbolzen, die von der oberen Prüfkassette in Richtung der unteren Prüfkassette abstehen, auf den Rand des Nadelbetts der unteren Kassette definiert. Erst hier baut sich die endgültige Schließkraft auf. Die Prüfvorrichtung stellt so ein geschlossenes Kräftesystem dar, bestehend aus dem Prüfling, der oberen Kassette, der Kopfplatte, welche die obere Kasette aufnimmt, den Führungssäulen, der Traverse, dem Zylinder des Stellglieds, dessen Kolben, dem Joch, der unteren Kassette und wiederum dem Prüfling dar.

Die Stützzylinder halten den Prüfkopf in seiner Ruhelage unter Abstand von dem Transportband (der Bezugsebene) und kompensieren das Eigengewicht der Prüfvorrichtung.

In der Zeichnung ist ein Ausführungsbeispiel der Erfindung wiedergegeben, das anhand der nachfolgenden Beschreibung näher erläutert wird. Es zeigen:
- Fig. 1: eine Draufsicht der Vorrichtung,
- Fig. 2: die Vorrichtung im Ruhezustand,

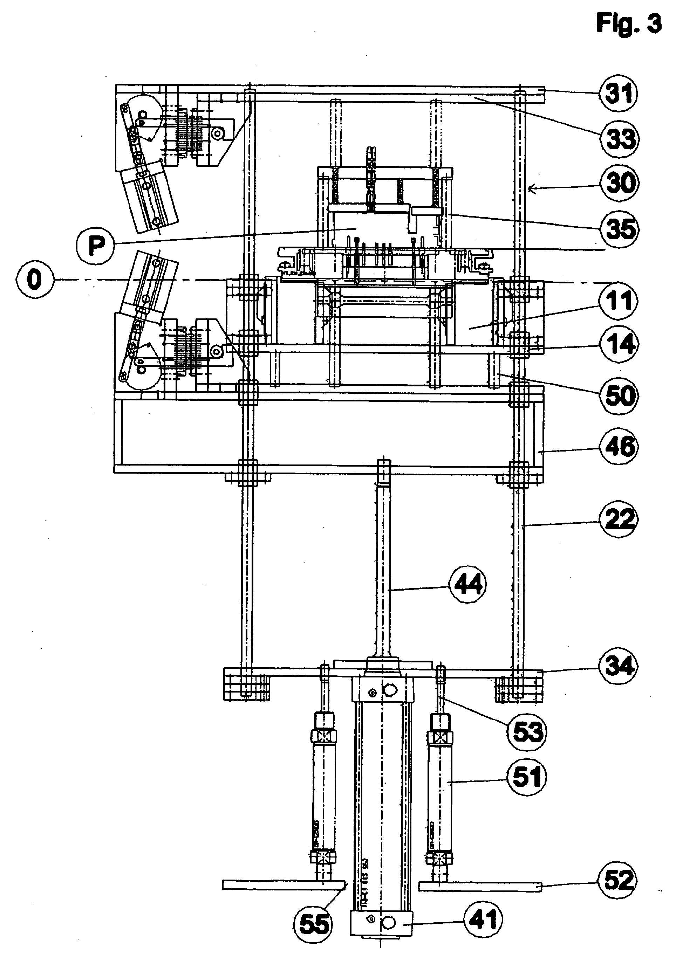

- Fig. 3: die Vorrichtung im Prüfzustand.

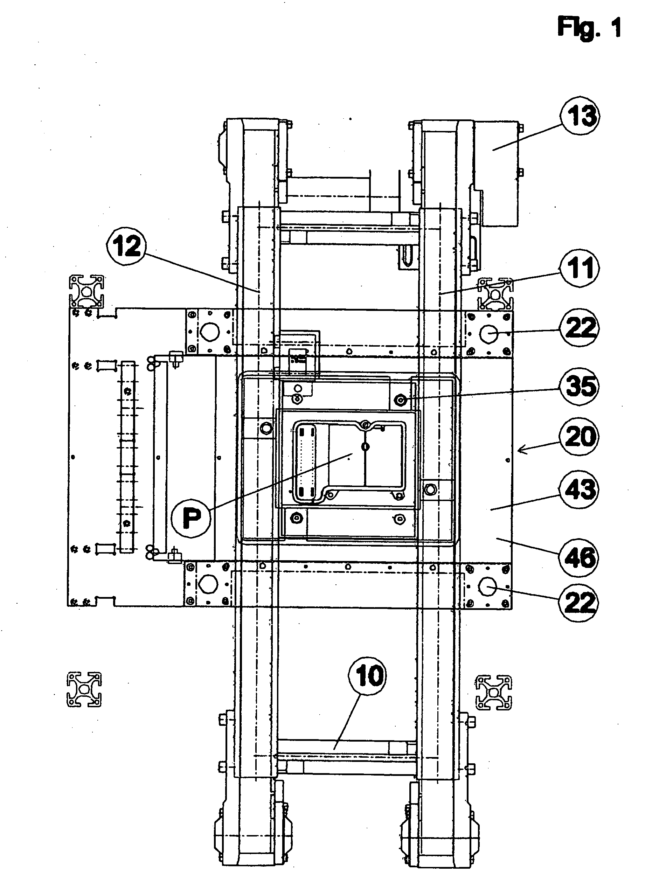

Gemäß Fig. 1 ist eine Transporteinrichtung 10 vorgesehen, die Prüflinge P durch eine Prüfvorrichtung 20 hindurchleitet.

Die Transporteinrichtung 10 besteht bei dem dargestellten Ausführungsbeispiel aus zwei unter Abstand voneinander angeordneten Förderbändern 11 und 12, die von einem Motor 13 angetrieben ständig umlaufen.

Die Oberflächen der Förderbänder 11, 12 bilden eine Bezugsebene 0, in der die Prüflinge P zugeführt werden.

Ein Rahmen 30 besteht aus einer oberen Kopfplatte 31 und einer unteren Traverse 34. Die obere Kopfplatte 31 und die Traverse 34 sind durch Säulen 22 miteinander fest verbunden und bilden so den Rahmen 30, durch den sich die Förderbänder 11 und 12 hindurch erstrecken und der in einer Trägerplatte 14 gleitend geführt ist.

An der Kopfplatte 31 ist eine obere Prüfkassette 33 durch eine pneumatische Spannvorrichtung austauschbar befestigt, die sich zwischen den Säulen 22 befindet.

An der Traverse 34 ist der Hauptzylinder 41 eines Stellglieds mit einer ausfahrbaren Kolbenstange 44 befestigt. Das Ende der Kolbenstange 44 ist mit einem Joch 46 verbunden, das auf den Säulen 22 gelagert ist und in ihrer Längsrichtung verschiebbar ist.

Das Joch 46 trägt die pneumatisch gespannte, wechselbare untere Prüfkassette 43. Auf ihr sind, aufgestockt durch Distanzen 45, die Nadelbettplatte mit den prüflingsspezifisch angeordneten gefederten Auswerfern 47 und gefederten Kontaktnadeln 48, sowie den Fangstiften 49 angebracht. Die Auswerfer 47 halten den Prüfling bis zum Auftreffen der Niederhalter 32 der oberen Kassette 33 auf Abstand zu den Kontaktnadeln 48, damit der Prüfling durch die Gesamtheit der Niederhalter lotrecht auf die Kontaktstifte herabgedrückt wird.

Im Bereich des Hauptzylinders 41 sind Stützzylinder 51 angeordnet, die an einer Bodenplatte 52 befestigt sind. Die Bodenplatte 52 ist gegenüber der Bezugsebene 0 fest angeordnet und weist ein Fenster auf, durch welches der Hauptzylinder 41 im Verlauf seines Hubes nach unten tauchen kann. Die Enden der Kolbenstangen 53 der Stützzylinder 51 sind an der Traverse 34 befestigt.

Die Kassetten 33 und 43 sind durch jeweils eine pneumatische Spannvorrichtung austauschbar und tragen an ihrer der Spannvorrichtung zugewandten Seite Übergabekontakte, die die zu messenden Signale einer geeigneten Auswerteinheit zuführen.

Die obere Kassette 33 kann zusätzlich zu den Niederhaltern ebenfalls mit Kontaktstiften wie 48 versehen werden, die in diesem Falle nach unten zeigen.

Der Prüfling P wird auf den Förderbändern 11 und 12 ruhend in der Bezugsebene 0 der Vorrichtung 20 zugeführt. Beim Ausfahren der Kolbenstange 44 des Hauptzylinders 41 bewegt sich das Joch 46 mit der Kassette 43 nach oben, zentriert den Prüfling P durch Auffädeln auf den Fangstiften 49 und hebt ihn mit den Auswerfern 47 aus der Ruhelage vom Transportband ab. Der Prüfling berührt dabei die Kontaktnadeln 48 noch nicht.

In dieser Stellung endet der untere Teilhub durch Auftreffen des Joches 46 mit seinen Anschlägen 50 auf die Trägerplatte 14 der Bezugsebene 0. In der kontinuierlichen Fortsetzung des Hubes der Kolbenstange 44 des Hauptzylinders 41 schiebt sich der Zylinder 41 mit der Traverse 34 nach unten durch das Fenster 55 durch die Bodenplatte 52 hindurch, wodurch über die Säulen 22 die Kopfplatte 31 mit der Cassette 33 nach unten bewegt wird.

Die Stützzylinder 51 dienen dabei als pneumatische Federn mit den Kolbenstangen 53, die an der Traverse 34 befestigt sind. Sie halten den Rahmen 30 vor Beginn des zweiten Teilhubes auf einer Ruhelage relativ zum Transportband. Sie werden unabhängig vom Betriebszustand des Prüfkopfs stets mit einem gleichbleibenden Druck beaufschlagt, der eine die Gewichtskraft des Prüfkopfes leicht übersteigende Abstützkraft hervorbringt. Erst mit Auftreffen des Joches 46 mit seinen Anschlägen 50 auf die Trägerplatte 14 der Bezugsebene 0 und dem beginnenden Herabdrücken des Rahmens 30 mitsamt dem Hauptzylinder 41 werden die Kolbenstangen 53 der Stützzylinder 51 eingedrückt.

Beim Auftreffen der Niederhalter 32 der oberen Prüfkassette 33 auf den Prüfling P wird nur der Prüfling P gegen die geringe Federkraft der Auswerfer 47 auf das Nadelbett mit den Kontaktstiften 48 der unteren Kassette 43 gedrückt. Erst ab hier beginnt der eigentliche Kontaktierhub, welcher den Prüfling gegen die Federkraft der Kontaktnadeln in das Nadelbett drückt und so den zum Prüfen erforderlichen Kontakt herstellt. Dieser Resthub endet mit dem Auftreffen der Distanzbolzen 35 auf den Rand des Nadelbettes der unteren Kassette 43. Dabei bleibt der Prüfling stets frei vom Band.

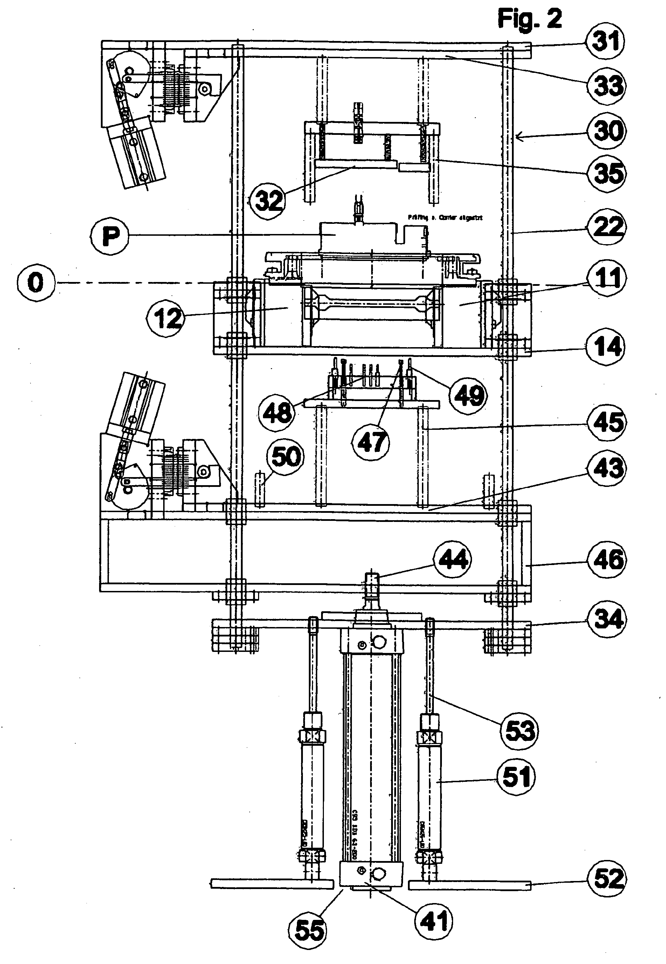

Wenn nach Beendigung der Prüfung die Kolbenstange des Hauptzylinders 41 einzieht, wird zunächst die obere Kassette 33 vom Prüfling abgehoben und dann erst die untere Prüfkassette 43 wieder abgesenkt und die Vorrichtung in die Position gemäß Fig. 2 zurückgefahren.

Dies stellt einen großen Vorteil gegenüber Prüfköpfen mit fest definiertem Weg dar. Das Hubende des Hauptzylinders wird durch das Auftreffen der Distanzbolzen 35, die von der oberen Prüfkassette in Richtung der unteren Prüfkassette abstehen, auf den Rand des Nadelbetts der unteren Kassette definiert. Erst hier baut sich die endgültige Schließkraft auf. Die Prüfvorrichtung stellt dann ein geschlossenes Kräftesystem dar, bestehend aus dem Prüfling P, den Niederhaltern 32 und den Distanzbolzen 35, der oberen Kassette 33, der Kopfplatte 31, der Säulen 22, der Traverse 34, dem Hauptzylinder 41, seiner Kolbenstange 44, dem Joch 46 mit der unteren Kassette 43, und dem Prüfling P dar.

Die Stützzylinder 51 halten die Prüfvorrichtung unter dem Band in der Ruhelage, sorgen für die Abfolge des Auftreffens der Kassetten auf den Prüfling und kompensieren das Eigengewicht des beweglichen Teiles der Prüfvorrichtung, dem Rahmen 30 mitsamt Kassetten 43 und 33 und Joch 46.

## Patentansprüche

1. Vorrichtung zum Prüfen elektrischer Bauteile mit einer Transporteinrichtung (10) zum Zuführen der zu prüfenden Bauteile (P) und mindestens einem Satz Prüfkassetten, die mit den Kontakten des zu prüfenden Bauteils in Eingriff bringbar sind, wobei die Vorrichtung einen Rahmen (30) aufweist, an dem eine obere Prüfkassette (33) fest und eine untere Prüfkassette (43) bewegbar gelagert ist, und der Rahmen ein Stellglied (41) trägt, das zum Verschieben der unteren Prüfkassette (43) in Richtung des Prüflings (P) angeordnet ist, **dadurch gekennzeichnet, dass** der Rahmen (30) die Transporteinrichtung (10) vollständig umschließt und durch das Stellglied (41) in einer Trägerplatte (14) heb- und senkbar gelagert ist.

2. Vorrichtung nach Anspruch 1, **dadurch gekennzeichnet, dass** der Rahmen (30) auf Stützzylindern (51) pneumatisch gefedert gelagert ist.

3. Vorrichtung nach einem der Ansprüche 1 und 2, **dadurch gekennzeichnet, dass** der Rahmen (30) vertikal verlaufende Säulen (22) und eine untere Traverse (34) aufweist, an der das Stellglied (41) befestigt ist und auf den Säulen (22) ein Joch (46) verschiebbar gelagert ist, mittels dem die untere Prüfkassette (43) heb- und senkbar angeordnet ist.

4. Vorrichtung nach mindestens einem der Ansprüche 1 bis 3, **dadurch gekennzeichnet, dass** der Rahmen (30) eine obere Kopfplatte (31) aufweist, an der die den Prüfling (P) von oben beaufschlagende Kassette (33) angeordnet ist.

5. Vorrichtung nach Anspruch 3, **dadurch gekennzeichnet, dass** das Joch (46) mindestens einen austauschbaren Anschlag (50) aufweist, der den Abstand des Jochs (46) von der Unterseite der Trägerplatte (14) bzw. einer Bezugsebene (0) bestimmt.

6. Vorrichtung nach mindestens einem der Ansprüche 1 bis 5, **dadurch gekennzeichnet, dass** die den Prüfling (P) von oben beaufschlagende Prüfkassette (33) nach unten vorstehende Distanzstifte (35) aufweist, die seitlich des Prüflings (P) zum Abstützen auf der nach oben weisenden Fläche des Nadelbetts der unteren Prüfkassette (43) angeordnet und ausgebildet sind.

## Claims

1. An apparatus for testing electrical components, with a conveying device (10) for feeding the components (P) to be tested and at least one set of test cassettes which can be brought into engagement with the contacts of the component to be tested, wherein the apparatus has a frame (30) on which an upper test cassette (33) is mounted stationary and a lower test cassette (43) is movably mounted, and the frame carries an actuator (41) which is arranged to displace the lower test cassette (43) towards the test piece (P), **characterised in that** the frame (30) completely encloses the conveying device (10) and is mounted so that it can be raised and lowered by the actuator (41) in a carrier plate (14).

2. An apparatus according to Claim 1, **characterised in that** the frame (30) is pneumatically spring-mounted on support cylinders (51).

3. An apparatus according to any one of Claims 1 and 2, **characterised in that** the frame (30) has vertically extending columns (22) and a lower cross-member (34), on which the actuator (41) is secured, and on the columns (22) a yoke (46) is displaceably mounted, by means of which the lower test cassette (43) is arranged so that it can be raised and lowered.

4. An apparatus according to at least one of Claims 1 to 3, **characterised in that** the frame (30) has an upper head plate (31), on which is arranged the cassette (33) acting on the test piece (P) from above.

5. An apparatus according to Claim 3, **characterised in that** the yoke (46) has at least one replaceable stop member (50) which determines the distance of the yoke (46) from the underside of the carrier plate (14) or a reference plane (0).

6. A test apparatus according to at least one of Claims 1 to 5, **characterised in that** the test cassette (33) acting on the test piece (P) from above has downwardly projecting spacing pins (35) which are arranged and formed laterally of the test piece (P) to bear on the upwardly facing surface of the needle bed of the lower test cassette (43).

## Revendications

1. Dispositif pour tester des composants électriques avec un dispositif de transport (10) pour l'amenée des composants destinés à être testés (P) et au moins un jeu de cassettes de test qui peuvent être mises en prise avec les contacts du composant destiné à être testé, le dispositif comportant un châssis (30) sur lequel une cassette de test supérieure (33) est positionnée de manière fixe et une cassette de test inférieure (43) est positionnée de manière mobile et le châssis porte un organe de réglage (41) qui est agencé pour le déplacement de la cassette de test inférieure (43) dans la direction du composant destiné à être testé (P), **caractérisé en ce que** le châssis (30) entoure complètement le dispositif de transport (10) et est positionné de manière à pouvoir être soulevé et abaissé par l'organe de réglage (41) dans une plaque de support (14).

2. Dispositif selon la revendication 1, **caractérisé en ce que** le châssis (30) est positionné à l'aide d'une suspension pneumatique sur des cylindres d'appui (51).

3. Dispositif selon l'une quelconque des revendications 1 et 2, **caractérisé en ce que** le châssis (30) comporte des colonnes (22) s'étendant verticalement et une traverse inférieure (34) sur laquelle est fixé l'organe de réglage (41) et un support (46), à l'aide duquel la cassette de test inférieure (43) est positionnée de manière à pouvoir être soulevée et abaissée, est positionné de manière déplaçable sur les colonnes (22).

4. Dispositif selon l'une quelconque des revendications 1 à 3, **caractérisé en ce que** le châssis (30) comporte une plaque de tête (31) sur laquelle est placée la cassette (33) entrant en contact par le haut avec le composant destiné à être testé (P).

5. Dispositif selon la revendication 3, **caractérisé en ce que** le support (46) comporte au moins une butée interchangeable (50) qui détermine la distance entre le support (46) et la face inférieure de la plaque de support (14) ou un plan de référence (0).

6. Dispositif selon l'une quelconque des revendications 1 à 5, **caractérisé en ce que** la cassette de test (33) entrant en contact par le haut avec le composant destiné à être testé (P) comporte des goupilles d'écartement (35) faisant saillie vers le bas qui sont placées et formées sur le côté du composant destiné à être testé (P) pour s'appuyer sur la surface dirigée vers le haut du lit d'aiguilles de la cassette de test inférieure (43).
